# EUROPEAN PATENT APPLICATION

(11) **EP 4 614 816 A1**
(43) Date of publication of application: **10.09.2025**
(21) Application number: 24161197.9
(22) Date of filing: 04.03.2024
(51) Int. Cl.: H03K 17/0814, H03K 17/16, H03K 17/567

(54) **SOLID STATE CIRCUIT BREAKER, ESPECIALLY FOR AN AIRCRAFT, WITH A CONTROLLED CLAMPING CIRCUIT, ELECTRICAL CIRCUIT, AIRCRAFT, AND OPERATION METHOD**

(71) Applicant: Airbus S.A.S., 31700 Blagnac (FR)
(72) Inventor: STEINER, Gerhard, Taufkirchen (DE); KAPAUN, Florian, Taufkirchen (DE); DINKEL, Daniel, Taufkirchen (DE)
(74) Representative: OTN Airbus SAS

(57) **Abstract**

An improved SSCB 14 for use in an aircraft (100) is provided. The SSCB (14) comprises a main switching unit (32) configured to be switched off in the event of an excessive current and a clamping circuit (36) that comprises at least one passive electrical element (38, R₀, Rₙ) and a clamping switch unit (24). In one alternative, the clamping switch unit (24) comprises an electricals switch (20) and an active gate drive (26), especially configured to keep the clamping voltage (Vs) constant and/or to compensate for temperature dependencies or other deficiencies in a V-I-characteristic of the passive element (38). In a second alternative, the clamping circuit (36) has several parallel modules (Mₙ) each having at least one passive element (38, Rₙ, Cₙ) and an electrical switch (20, Sₙ) and a control unit (40) configured for a consecutive switching of the electrical switches (Sₙ) of the different modules (Mₙ).

## Description

The invention relates to a solid state circuit breaker including a clamping circuit. Further, the invention relates to an electrical circuit, especially for or of an aircraft, including such solid state circuit breaker. Further, the invention relates to an aircraft having such an electrical circuit or such a solid state circuit breaker, especially as safety device in an electrical propulsion system or an electrical energy supplying system. Still further, the invention relates to an operation method, a control device and a computer program for such solid state circuit breaker.

For technical background, reference is made to the following literatures:
[1] Wikipedia, "Circuit breaker", download from https://en.wikipedia.org/wiki/Circuit_breaker on February 07, 2024
[2] Wikipedia, "Clamper (electronics)", download from https://en.wikipedia.org/wiki/Clamper_(electronics) on January 10, 2024
[3] WO 2014/177874 A2
[4] WO 2022/272007 A2
[5] L. Camurca, J. Jacobsen and M. Liserre, "Passive Clamping Circuit for Reduced Switch Count in Solid State Circuit Breakers," 2021 IEEE 15th International Conference on Compatibility, Power Electronics and Power Engineering (CPE-POWERENG), 2021
[6] EP 0 701 313 A1
[7] US 11 515 815 B2

Literatures [5] and [6] disclose a solid state circuit breaker having the features of the characterizing part of claim 1, wherein the clamping circuit is a passive clamping circuit.

An object of the invention is to provide an improved solid state circuit breaker, especially for use in an aircraft.

For achieving such object, the invention provides a solid state circuit breaker having the features of enclosed claim 1. An electric circuit and an aircraft equipped with such solid state circuit breaker, an operation method, a control device and a computer program are subject-matters of the further independent claims.

Advantageous embodiments are subject-matters of the dependent claims.

The invention provides a solid state circuit breaker (SSCB) comprising a main switching unit configured to be switched off in the event that a current Iᵢₙ running through the solid state circuit breaker exceeds a maximum current threshold Iₘₐₓ, and a clamping circuit for absorbing energy and protecting against overvoltage wherein the clamping circuit is connected in parallel to the main switching unit and comprises at least one support circuit consisting of at least one passive electrical device and at least one clamp switching unit providing controllability of the path over the support circuit.

According to a first alternative of the invention, the clamp switching unit comprises an electrical switch and an active gate drive for the electrical switch wherein the active gate drive is configured to control the electrical switch such that it functions as a controlled resistor.

According to a second alternative of the invention, the clamping circuit comprises a parallel connection of several modules each comprising a series connection of one of the support circuits and one of the clamp switching units and a control unit configured to switch off the clamp switching units of the different modules one after the other.

The main switching unit may be realized as single electrical switch or multiple bidirectional electrical switches.

In some embodiments, the main switching unit is unidirectional and may be realized as single electrical switch. In these embodiments, the clamping circuit is preferably a unidirectional clamping circuit wherein the at least one clamp switch unit is a unidirectional clamp switch unit (e.g. realized with a single electrical switch). In some embodiments, the main switching unit is bidirectional and may be realized by multiple bidirectional electrical switches. In those embodiments, the at least one clamp switch unit is a bidirectional clamp switch unit (e.g. realized with multiple bidirectional electrical switches.

Preferably, the at least one passive electrical device of the support circuit is chosen from the group consisting of a resistor, a capacitor, a varistor, a diode, a TVS-diode, and a combination of these in series and/or parallel connection.

In some embodiments, the passive electrical device consists of a resistor and a capacitor in series connection. In some embodiments, the passive electrical device includes a TVS-diode.

In some embodiments, the active gate drive is configured to control the voltage over the clamping circuit such that it is kept at a constant value during the whole switching procedure of the solid state circuit breaker.

In some embodiments, the active gate drive is configured to control the voltage over the clamping circuit such that it is adapted to a predefined target course of changing the voltage over the time.

In some embodiments, the active gate drive is configured to control the voltage over the clamping circuit such that an influence of temperature, nonlinearities and/or V-I-characteristics of the at least one passive electrical device is compensated.

In some embodiments, the control unit is configured to switch off one of the modules depending on the voltage over the main switching unit.

In some embodiments, the control unit is configured to switch off one of or the next of the modules when the voltage over the main switching unit is or falls below a predefined minimum clamping voltage.

According to another aspect, the invention provides a power distribution system for an aircraft, comprising at least one source of electrical energy and at least one sink for electrical energy and at least one solid state circuit breaker according to any of the aforementioned embodiments connected between the at least one source and the at least one sink.

According to another aspect, the invention provides an aircraft comprising such a power distribution system or at least one solid state circuit breaker according to any of the aforementioned embodiments.

In some embodiments, the power distribution system powers an electric propulsion system of the aircraft.

According to another aspect, the invention provides an operation method for the solid state circuit breaker of any of the aforementioned embodiments, comprising:
A) keeping the main switching unit and the at least one clamp switching unit closed (in the ON-state) during normal operation,
B) opening the main switching unit in the case that the current running through the solid state circuit breaker exceeds the maximum current threshold,
C) absorbing energy and avoiding overvoltage by means of the clamping circuit while shutting down the current path over the clamping circuit, wherein step C) comprises at least one of the steps:
   C1) shutting down the current path over the clamping circuit while controlling the voltage over the clamping unit by means of the active gate driver or
   C2) shutting down the current path by subsequently opening (setting in the OFF-state) the switching units of the different modules of the clamping circuit.

In some embodiments, step C1) comprises the step:
C1-1) keeping the voltage over the clamping circuit constant during the shut-off procedure.

In some embodiments, step C1) comprises the step:
C1-2) controlling the voltage over the clamping circuit in accordance with a predefined target course for changing the voltage over the time.

In some embodiments, step C1) comprises the step:
C1-3) controlling the voltage over the clamping circuit in order to compensate an influence of temperature, nonlinearities and/or V-I-characteristics of the at least one passive electrical device.

In some embodiments, step C2) comprises the step:
C2-1) opening one or the next one of the modules depending from the voltage over the main switching unit.

In some embodiments, step C1) comprises the step:
C2-2) opening one of or the next one of the modules when the voltage over the main switching unit is or falls below a predefined minimum clamping voltage.

According to another aspect, the invention provides a control device for the solid state circuit breaker of any of the aforementioned embodiments, wherein the control device is configured to cause the solid state circuit breaker to execute the steps of the operation method according to any of aforementioned embodiments.

According to another aspect, the invention provides a computer program comprising instructions to cause the solid state circuit breaker of any of the aforementioned embodiments to execute the steps of the operation method according to any of the aforementioned embodiments.

Preferred embodiments of the invention provide a SSCB that can be safely operated in a large temperature range wherein passive electrical elements with less weight can be used. Thus, the SSCB can be adapted more easily to use in an aircraft.

Conventional gate drivers normally apply a constant voltage to a gate (e.g. 5 V) to turn on a power semiconductor device and a constant voltage to a gate (e.g. 0 V) to turn off a power semiconductor device. Hence, with conventional gate drivers, an electrical switch is turned on and off in a single step so that the electrical switch is either ON or OFF. Instead of this single step, an active gate driver such as used in one alternative of the invention is configured to shape the gate voltage. With an active gate driver, intermediate switching states between ON and OFF can be achieved. Thus, with the active gate driver the gate voltage of an electrical switch of the switch unit can be controlled and shaped. For example, the system can be adapted to different working conditions, such as temperatures. This enables optimization of the dimensioning of the SSCB so that weight can be saved. By using parallel modules as proposed in the second alternative of the invention, the electrical switches can be dimensioned significantly smaller than the main switches. This also reduces costs and weight significantly. Further, redundancy can be improved.

Embodiments of the invention are explained below referring to the accompanying drawings in which:
- Fig. 1: is a schematic plan view of an embodiment of an aircraft with a power distribution system comprising semiconductor switch circuit breakers;
- Fig. 2: a block diagram of a power distribution system, especially of the aircraft of Fig. 1, protected with a semiconductor switch circuit breaker (SSCB);
- Fig. 3: a block diagram for embodiments of the SSCB with a clamping circuit comprising a support unit and a switch, in a unidirectional configuration;
- Fig. 3a: a block diagram as in Fig. 3 for a bidirectional configuration;
- Fig. 4a to 4f: block diagrams of different possible embodiments of the support unit;
- Fig. 5: a block diagram of a first embodiment of the SSCB with a first embodiment of the clamping circuit;
- Fig. 6: a diagram showing the course of different voltages and currents in the SSCB of Fig. 5 during a switching process;
- Fig. 7: a block diagram of a second embodiment of the SSCB with a second embodiment of the clamping circuit;
- Fig. 8: a diagram similar to Fig. 6 showing the course of voltages and currents during switching of the SSCB of Fig. 7;
- Fig. 9: a block diagram of a third embodiment of the SSCB with a third embodiment of the clamping circuit;
- Fig. 10: a diagram showing switching voltages over a current flowing through the SSCB of Fig. 9; and
- Fig. 11: a block diagram of a fourth embodiment of the SSCB with a fourth embodiment of the clamping circuit.

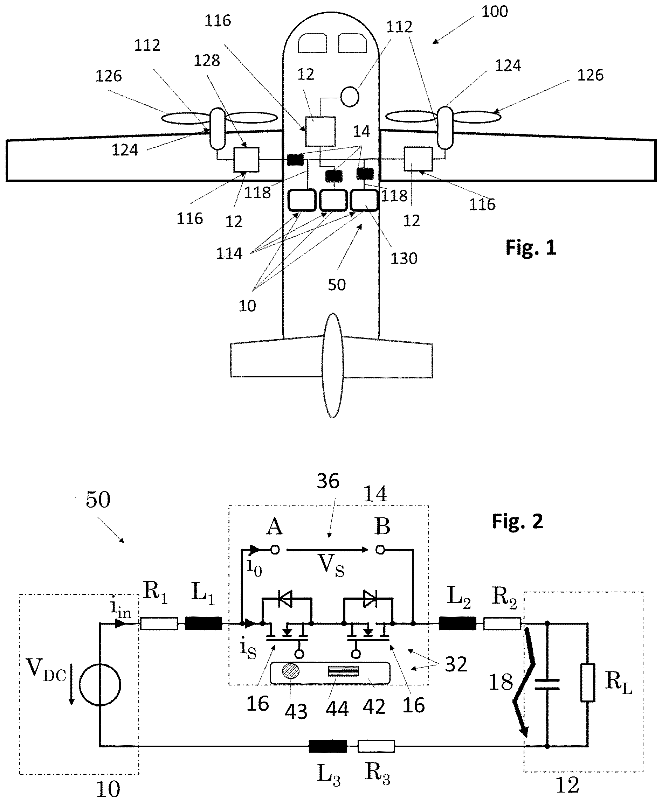

Fig. 1 shows an aircraft 100 with a power distribution system 50 protected by semiconductor switch circuit breakers (SSCB) 14.

The aircraft 100 according to the example shown in Fig. 1 comprises at least one DC energy source 10 providing a DC energy over a dc bus 118 with a dc-bus voltage V_{DC}, at least one power electronic 116 as example for a sink 12 of the power distribution system 50, and at least one electrical consumer 112 supplied with electrical power from the energy source 10 via the power electronic 116.

The electrical consumer 112 can be of any kind of aircraft component to be powered with AC or DC power such as an electrical actor, a motor pump, or an electric motor 124. In some embodiments, the power distribution system 50 is part of an electrical propulsion system 120 of the aircraft 100 wherein, for example, the motor 124 is a propulsion motor for driving a flight propulsion element such as a propeller 126 of the aircraft 100.

In some embodiments, the power electronic 116 is an inverter 128 for supplying the electrical consumer 112 with AC power converted from the DC energy source 10 which may be or include a battery 130 or a fuel cell or a DC power network including several batteries 130 and/or fuel cells (not shown).

Fig. 2 shows a block diagram with an exemplary circuit for a power distribution system 50 such as the power distribution system 50 of the aircraft of Fig. 1. The power distribution system 50 may contain single or multiple sources 10 and sinks 12. For simplicity only one source 10 and only one sink is shown here. The at least one source 10 provides electrical energy with a source voltage V_{DC} (e.g., the dc bus voltage) and a current iiₙ. The at least one sink 12 is provided with the electrical energy from the source 10 via a solid state circuit breaker (SSCB) 14 connected therebetween.

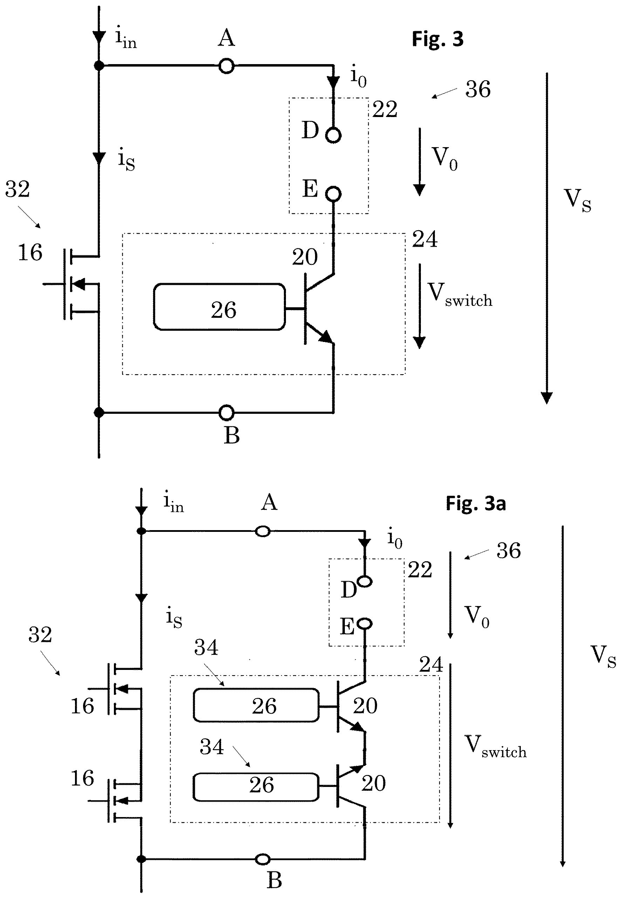

In case of failures, e.g. a short circuit 18, the SSCB 14 acts as a safety device, limiting the fault current and disconnecting the sources 10 and sinks 12. The SSCB 14 has a main switching unit 32 with at least one main electrical switch 16. A unidirectional SSCB 14 can only provide protection in a single direction and, therefore, includes only one main electrical switch 16 (as this is for example shown in Figs. 3, 5, 7, 9, and 11). Fig. 2 shows a bidirectional SSCB including two main electrical switches 16. The term "electrical switch" is used as a representation of any semiconductor switch such as IGBT, MOSFET, .... Although the circuits shown in the Figures contain explicit symbols normally used for a specific kind of semiconductor switch, it should be clear that other suitable semiconductor switches can be used as main electrical switches 16 and electrical switches 20 of a clamp switching unit 24 explained in more detail below.

In normal operation, the main electrical switch(es) 16 is/are open (ON) so that the sink 12 is connected to the source 10 and provided with DC electrical energy with the DC bus voltage V_{DC} with a line current iᵢₙ.

The main switching unit 32 is configured to be switched off in the event that a current Iᵢₙ running through solid state circuit breaker 14 exceeds a maximum current threshold Iₘₐₓ.

For example, the main switching unit 32 of the SSCB 14 comprises a control device 42 which detects the current iᵢₙ flowing from the source 10 to the sink 12 and triggers a switching process of its main switch(es) 16 in case that this line current iᵢₙ exceeds a predefined current threshold value iₘₐₓ (maximum current imax).

In some embodiments, the control device 42 comprises a processor 43 and a memory 44 with a computer program containing instructions for operation of the SSCB 14.

Cutting a (fault) current leads to two major technical challenges:
1) The energy in the current path (mainly based on inductances L₁, L₂, L₃) has to be absorbed by the SSCB 14;
2) The switch voltage Vs has to be controlled within certain limits.

An additional clamping and overvoltage protection circuit - referred to as clamping circuit 36 in the following - is used to address these challenges. In general, the clamping circuit 36 is inserted between the terminals A and B. As known from the literature mentioned above, commonly used clamping circuits consist of varistors, TVS-diode, RCD-snubbers and also combinations of these.

In the following, different embodiments of the clamping circuit 36 which is connected between terminals A and B, providing the necessary functionality and additional features are described referring to Figs. 3 to 11. For simplicity, most examples shown are in unidirectional SSCBs 14. For a bidirectional SSCBs 14, a second electrical switch 20 is added to the clamp switching unit 24 in anti-series connection such as shown in Fig. 3a.

Referring to Fig. 3, and 3a two main functional blocks are connected between terminals A and B.

The first main functional block is a support circuit 22 consisting of passive electrical devices 38 like resistors R, capacitors C, diodes, especially TVS-diodes 30, varistors 28 and combinations of theses. These are connected at the terminals D and E in Fig. 3.

The second main functional block is a clamp switching unit 24 which provides controllability of the path over the clamping circuit 36. The clamp switching unit 24 includes at least one electrical switch 20, S₀ and a gate drive 34. While a standard gate drive would enable the option of only opening and closing the path for the current flow, the gate drive 34 of the embodiments of Figs. 3, 3a, 5, and 7 is an active gate drive 26 enabling the use of the electrical switch(es) 20, S₀ as a controlled resistor (e.g. for enabling controlling the voltage over the switch). For example, an active region of a bipolar junction transistor used as electrical switch 20 is controlled by the active gate drive 26.

As mentioned above, the clamp switching unit 24 may comprise either one single electrical switch 20, S₀ such as shown in Figs. 3, 5, and 7 for unidirectional operation only, or two anti-serial connected switches 20 for a bidirectional SSCB 14 as indicated in Fig. 3a. Fig. 3 shows an electric schematic for unidirectional operation. Bidirectional operation requires an additional electrical switch, see Fig. 3a. The main electrical switch 16 is for example a SiC MOSFET. The V₀ is the voltage over the supporting unit 22, i₀ is the current over the path of the clamping circuit 36, Vs is the switch voltage between A and B which corresponds to the voltage over the SSCB 14 and over the clamping circuit 36. is is the current over the main switching unit 32. iᵢₙ is the current flowing through the SSCB 14, v_{switch} is the voltage over the clamp switching unit 24 (e.g., a voltage V_{IGBT} over an IGBT used as electrical switch 20).

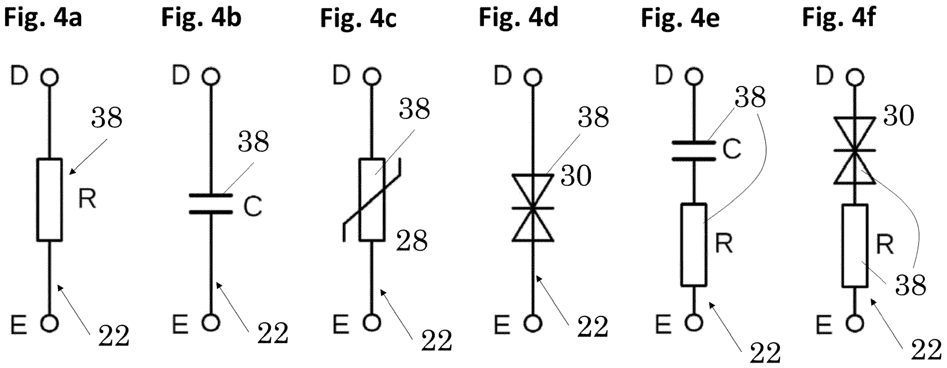

Figs. 4a to 4f show different examples of the support circuit 22 which is a passive circuit for connection between terminals D and E of Fig. 3. Note that many options of series and parallel connections of these passive elements exist.

In order to understand the working principle of the SSCB 14 of the different embodiments of the invention, multiple examples with increasing complexity are described in the following.

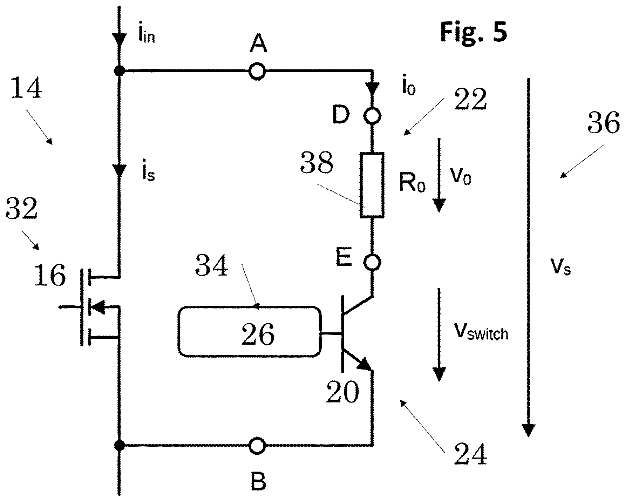

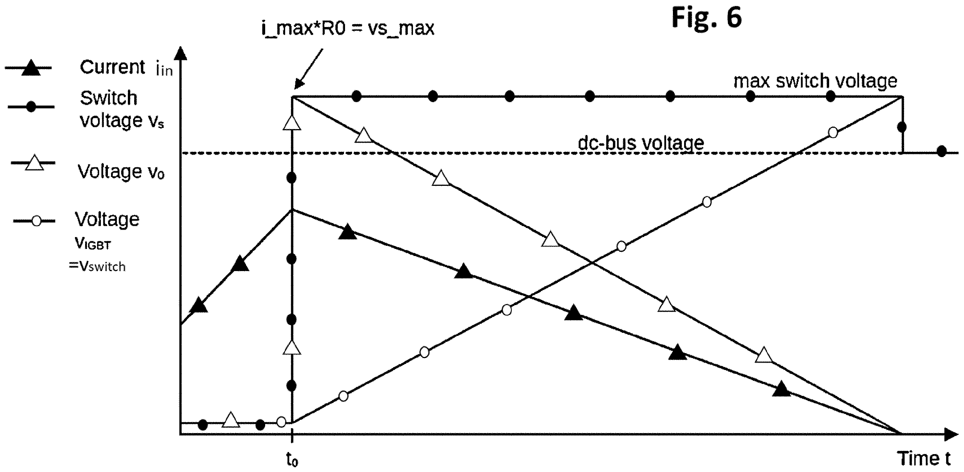

Fig. 5 shows a first embodiment of the SSCB 14 wherein the support circuit 22 consists of a resistor R₀ and the clamp switching unit comprises the at least one electrical switch 20 (e.g. the IGBT) and the active gate driver 26. Fig. 6 shows the signals over time in case of a failure event.

The current iᵢₙ has a positive gradient due to a short circuit 18 in the system 50. In other words, the source 10, which acts as a voltage source, is feeding current into the short circuit position. At time t₀ the current value iₘₐₓ is reached which triggers the switching event of the SSCB 14. By switching off the main electrical switch 16 the current is will be completely commutated towards i₀. Because of the electrical switch 20 of the clamp switching unit 24 being fully turned on it leads to SSCB voltage V_{S}=iₘₐₓ*R₀. It becomes clear that R₀'s value is determined by the maximal current iₘₐₓ and the given maximal voltage V_{Smax} of the SSCB 14.

Since Vs is greater than the dc-bus voltage V_{DC} of the system 50, the current iᵢₙ begins to decrease. Its gradient is defined by the difference ΔV=V_{DC}-V_{S}, considering a pure inductive dc-bus impedance. Hence, the linear decrease of the voltage V₀ has to be compensated by v_{switch} in order to keep V_{S}=V_{Smax}, which is the desired (or maximal) SSCB voltage. Utilizing an active gate drive 26 or equivalent technique, the electrical switch 20 of the clamp switching unit 24 is operated as a controlled voltage source. The whole procedure ends when the current i₀ (=iᵢₙ since the main electrical switch 16 is off) reaches zero. All switches 16, 20 are turned off at this point in time.

It can be theoretically proven that with optimal dimensioning, the energy absorbed in the resistor R₀ is 2/3 of the total energy. Consequently, 1/3 is absorbed in the electrical switch 20 of the clamp switching unit 24. Some advantages of this clamping circuit 36 compared to the state of the art are:
1) The clamping voltage Vs can be kept at a constant value during the whole procedure.
2) The clamping voltage Vs can be adapted via control during runtime.
3) Any influence of temperature, nonlinearities or V-I-characteristics of passive elements R, C, 28, 30 can be compensated.

In conclusion, the clamping circuit 36 of the embodiment of Fig. 5, 6 provides reasonable advantages. But it should be noted that dissipating 1/3 of the energy in the electrical switch 20 may be too much in most applications. Consequently, further improvements are implemented in further embodiments of the clamped SSCB 14 in order to overcome this disadvantage. These will be described in the following examples.

A step forward is to add a capacitor C₀ in series. With this measure the energy absorbed by the electrical switch 20, S₀ can be reduced.

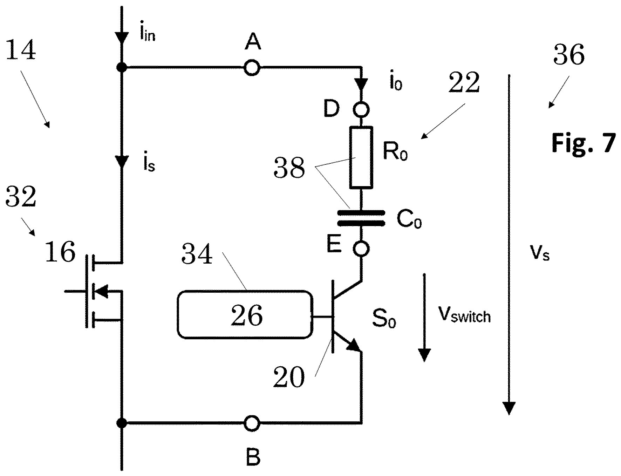

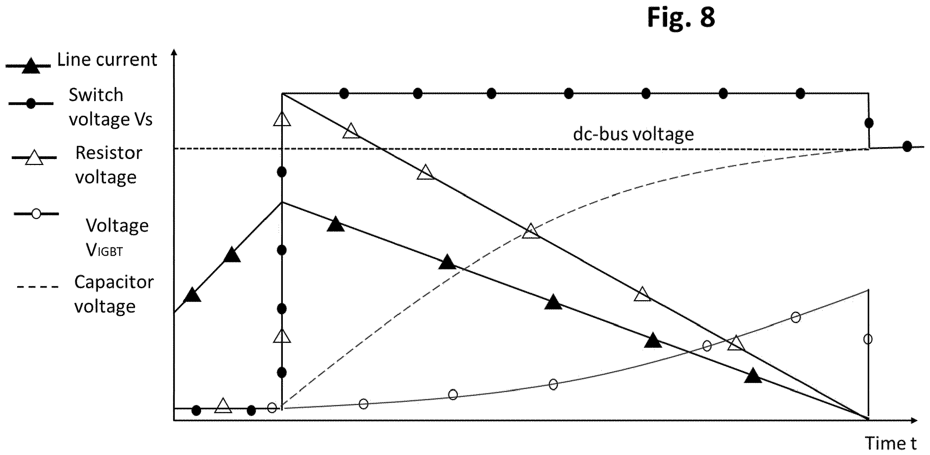

Fig. 7 shows a second embodiment of the SSCB 14 wherein the support circuit 22 consists of a resistor R₀ and a capacitor C₀ in series connection and the clamp switching unit 24 comprises the at least one electrical switch 20 (e.g. the IGBT) and the active gate driver 26. Fig. 8 shows the signals over time in case of a failure event. Also a unidirectional configuration is shown in Fig. 7, it should be noted that a bidirectional configuration is also possible, refer to Fig. 3a.

The capacitance C₀ is chosen in a way that charging it with the (decreasing) load current iᵢₙ provides an additive voltage component. Since the total switch voltage Vs is a sum of the resistor voltage, capacitor voltage and electrical switch voltage V_{switch} (e.g., V_{IGBT}), the voltage contribution of the electrical switch 20 can be reduced with this measure. Consequently, the energy absorbed by the electrical switch 20 is decreased as well.

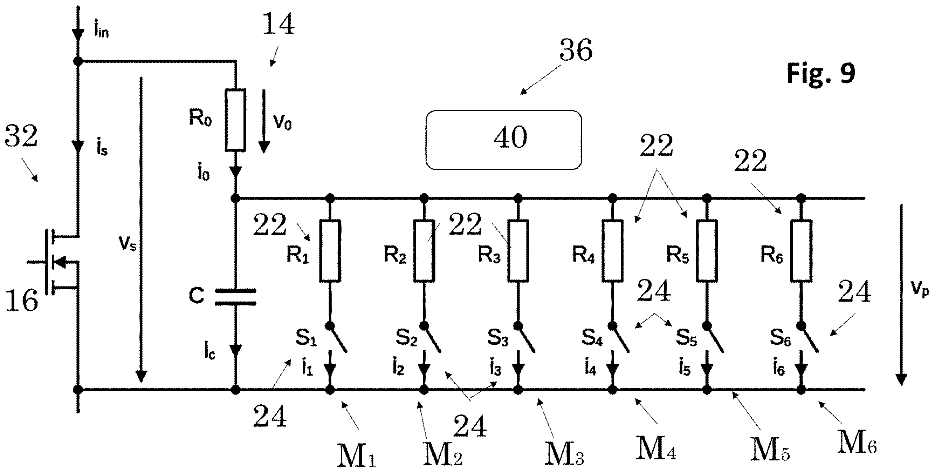

In the following a second alternative of the clamping circuit 36 is explained referring to Figs. 9 to 11. Although the principle of the second alternative is explained for simplicity on examples for unidirectional function, it works also for a bidirectional configuration by adding electrical switches similar as shown in Fig. 3a. The alternative of the clamping circuit implements an approach towards parallel modules Mₙ with n=1, 2, 3.... Each module Mₙ comprises the functional blocks of the previously described clamping circuits 36, i.e., the support circuit 22 and the switching unit 24. Fig. 9 shows multiple of these modules Mₙ in parallel. The switching unit 24 of each module Mₙ comprises the electrical switch 20, Sₙ and the gate drive 34 which also may be a conventional gate drive (or an active gate drive 26). The support circuit 22 consists of one or several of the passive electrical devices 38 as mentioned above, examples of the support circuits usable for each of the modules Mₙ are shown in Figs. 4a to 4f.

Further, the clamping circuit 36 comprises a control unit 40 which may be implemented as part of the SSCB control device 42 and which is configured to control the electrical switches 20, Sₙ in the way as described in the following.

During normal operation all electrical switches 16, 20, S_{N} of the SSCB 14 are closed. The main part of the load current iᵢₙ is passing through the main switching unit 32. The increase of failure current iᵢₙ towards a certain value iₘₐₓ triggers the main switch 16 to open up. The result is that the total load current iᵢₙ flows through the clamping circuit i₀=iᵢₙ. Since the switches S₁, ...Sₙ, ...S₆ are still closed, the voltage is approximately V_{S}=i₀*(R₀+(R1∥R2∥...Rₙ ...∥R6), if the influence of the capacitor is neglected.

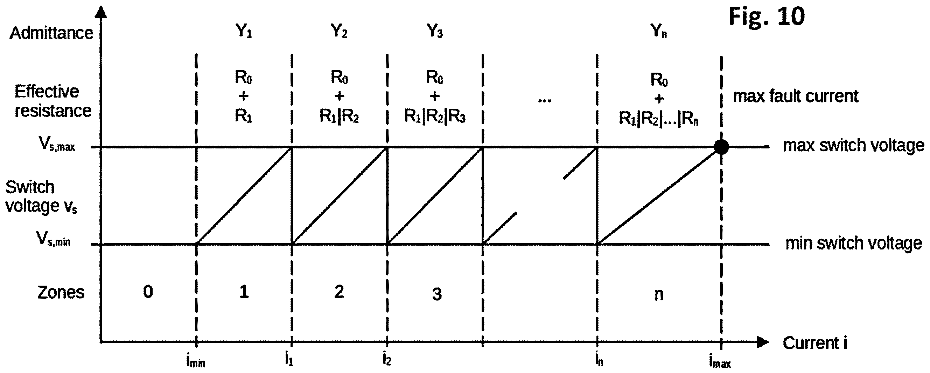

The voltage V_{S} will decrease according to the current i₀. A minimal switch voltage V_{S,min} is defined to consecutively open all the electrical switches 20, Sₙ in modules Mₙ of the total clamping circuit 36. The principle is shown in the Fig. 10 and is explained straight forward. Fig. 10 shows a graph wherein the overall switching voltage V_{S} is shown over the current i₀ (corresponding to iᵢₙ when the main electrical switch 16 is open, i.e., OFF). Each opening process of a switch S₆, S₅, S₄, ... will increase the resistance of the paralleled modules (R1, R2, ... R6) and, therefore, it increases the voltage V_{S}. This control does not need an active gate drive which reduces the complexity.

In Fig. 10, the maximum current iₘₐₓ which is present during time t₀ when the main switch 16 opens is shown at the right. In this nth zone the resistance of the parallel modules Mₙ is the smallest. The current i decreases from the maximum fault current, hence the overall switch voltage Vs decreases from the maximum switch voltage V_{S,max} until it reaches the minimum switch voltage V_{S,min}. This triggers open up the electrical switch 20, Sₙ of one of the modules. Since this increases the resistance of the parallel modules, the switch voltage is again high and decreases in the following until the switching of the electrical switch 20 of the next module is triggered. When all electrical switches 20 of all the modules are open, the switching procedure ends.

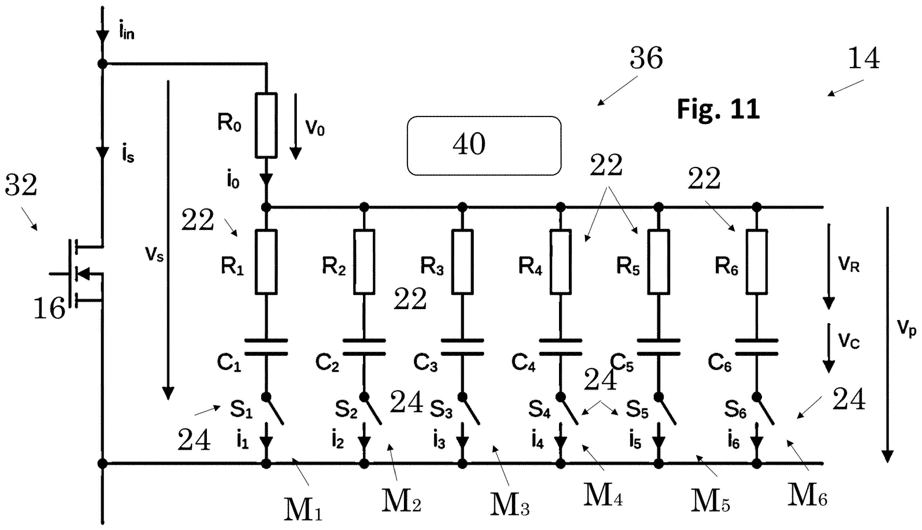

Referring to Fig. 11, capacitors Cₙ or other passive elements 38 can be added into this parallel clamping circuit 36 as well. Even completely different modules Mₙ can be used, e.g. a mixture of resistors, capacitors and TVS-diodes. In other words, the modules can differ from each other in the design of their functional blocks.

Until now, SSCBs 14 comprise passive clamping and overvoltage protection elements that mainly consists of TVS-diodes and varistors. While their main advantage is the simplicity of usage and no additional control is required, because the clamping voltage and energy absorption capability is determined in the selection process. Both parameters can easily be adapted by adding elements in series or in parallel. However, embodiments of the SSCB 14 according to the invention provide one, several or all of the following advantages over the prior art SSCBs:
1) Embodiments of the invention can provide less temperature dependencies so that variations of the clamping voltage can be decreased, minimized or even avoided. Typically, TVS-diodes suffer from a change of 0.1 %/°C. Especially in systems with large temperature working areas, this impedes the dimensioning of the system. With embodiments of the invention, a control to compensate for temperature dependencies is possible so that the dimensions can be made smaller, and the SSCB 14 is better suited for use in an aircraft 100.
2) Embodiment of the invention can compensate flat V-I-characteristics (especially varistors) which otherwise would lead to significantly varying clamping voltages. Embodiments of the invention provide possibilities to keep the clamping voltage constant which has advantages for the system dimensioning and voltage headroom. Thus, the SSCB 14 is better suited for use in an aircraft 100.

While known SSCB 14 need largely dimensioned solid states components, embodiments of the invention provide solutions for SSCB 14 that may be designed with less weight.

Embodiments of the SSCB 14 according to the invention have switchable passive elements 24, 38. The downside of this approach is the rising complexity. Control logic, semiconductor switches and (active) driver circuits are needed in addition to the passive elements 38. But this yields to a number of advantages:
1) Embodiments of the invention provide the option of using resistors R as passive clamping elements 38.

Basically, the electrical energy stored in the line inductance is transformed into heat in the clamping element 38 during the switching event. The body and the material itself (specific heat and other characteristics) of the passive element 38 determine its energy absorption capabilities. Their shape and volume can be adapted to create a compact overall design. In comparison to TVS-diodes and varistors, which can be used up to 175°C junction temperature, resistors R enable considerably higher temperatures and robustness.
2) Embodiments of the invention provide a controllable and flexible clamping voltage V_{S}.

Passive characteristics (e.g. V-I or temperature dependencies) can be neglected. The load current's di/dt is configurable.
3) Embodiments of the invention provide a resistive precharging option of the dc-bus.
4) By using parallel modules Mₙ the electrical switches Sₙ can be dimensioned significantly smaller than the main switch 16.

This reduces the cost and weight significantly.

### 5) Using parallel modules provides redundancy (device failure tolerance)

### Reference sign list:

- 10: source(s)
- 12: sink(s)
- 14: SSCB (solid state circuit breaker)
- 16: main electrical switch
- 18: short-circuit
- 20: electrical switch (clamp switching unit)
- 22: support circuit
- 24: clamp switching unit
- 26: active gate drive
- 28: varistor
- 30: TVS-diode
- 32: main switching unit
- 34: gate drive
- 36: clamping circuit
- 38: passive electrical device
- 40: control unit
- 42: control device
- 43: processor
- 44: memory
- 50: power distribution system
- 100: aircraft
- 112: electrical consumer
- 116: power electronic
- 118: dc bus
- 120: electrical propulsion system
- 124: motor
- 126: propeller
- 128: inverter
- 130: battery
- C: capacitor
- iᵢₙ: load current (failure current in event of failure, current through SSCB)
- i_{S}: current through main switching unit
- i₀: current through clamping circuit
- iₙ: current through nth module
- i_{C}: current through capacitor C
- Mₙ: nth module
- R: resistor
- Rₙ: resistor of nth module Mₙ
- S₀: electrical switch of clamping circuit
- Sₙ: electrical switch of module Mₙ
- V_{S}: overall switch voltage (voltage over SSCB, between terminals A and B)
- V_{switch'}: voltage over electrical switch of clamp switching unit
- V₀: voltage over 0^{th} passive electrical device
- Vₚ: voltage over parallel modules

## Claims

1. Solid state circuit breaker (14) comprising a main switching unit (32) configured to be switched off in the event that a current Iᵢₙ running through solid state circuit breaker (14) exceeds a maximum current threshold Iₘₐₓ, and a clamping circuit (36) for absorbing energy and protecting against overvoltage wherein the clamping circuit (36) is connected in parallel to the main switching unit (32) and comprises at least one support circuit (22) consisting of at least one passive electrical device (38) and at least one clamp switching unit (24) providing controllability of the path over the support circuit (22), **characterized in that**
a) the clamp switching unit (24) comprises an electrical switch (20) and an active gate drive (26) for the electrical switch (20) wherein the active gate drive (26) is configured to control the electrical switch (20) such that it functions as a controlled resistor, and/or
b) the clamping circuit (36) comprises a parallel connection of several modules (Mₙ) each comprising a series connection of one of the support circuits (22) and one of the clamp switching units (24) and a control unit (40) configured to switch off the clamp switching units (24) of the different modules (Mₙ) one after the other.

2. Solid state circuit breaker (14) according to claim 1, wherein the at least one passive electrical device (38) of the support circuit (22) is chosen from the group consisting of a resistor (R, Rₙ), a capacitor (C), a varistor (28), a diode, a TVS-diode (30), and a combination of these in series and/or parallel connection.

3. Solid state circuit breaker (14) according to claim 2, wherein the passive electrical device (38) consists of a resistor (R) and a capacitor (C) in series connection.

4. Solid state circuit breaker (14) according to any of the preceding claims wherein the active gate drive (26) is configured to control the voltage over the clamping circuit (36) such
4.1 that it is kept at a constant value during the whole switching procedure of the solid state circuit breaker (14) or
4.2 that it is adapted to a predefined target course of changing the voltage over the time.

5. Solid state circuit breaker (14) according to any of the preceding claims, wherein the active gate drive (26) is configured to control the voltage over the clamping circuit (36) such that an influence of temperature, nonlinearities and/or V-I-characteristics of the at least one passive electrical device is compensated.

6. Solid state circuit breaker (14) according to any of the preceding claims, wherein the control unit is configured to switch off one of the modules depending on the voltage over the main switching unit (32).

7. Solid state circuit breaker (14) according to claim 6, wherein the control unit is configured to switch off one of or the next of the modules when the voltage over the main switching unit (32) is or falls below a predefined minimum clamping voltage.

8. Power distribution system (50) for an aircraft (100), comprising at least one source (10) of electrical energy and at least one sink (12) for electrical energy and at least one solid state circuit breaker (14) according to any of the preceding claims connected between the at least one source (10) and the at least one sink (12).

9. Aircraft (100) comprising a power distribution system (50) according to claim 8 or at least one solid state circuit breaker according to any of the claims 1 to 7.

10. Aircraft (100) according to claim 9, wherein the power distribution system (50) is part of an electric propulsion system (52) of the aircraft (100).

11. Operation method for the solid state circuit breaker (14) according to any of the claims 1 to 8, or for the solid state circuit breaker of the power distribution system (50) according to claim 8 or of the aircraft (100) according to any of the claims 9 or 10, comprising:
A) keeping the main switching unit and the at least one clamp switching unit closed (ON) during normal operation,
B) opening the main switching unit in the case that the current running through the solid state circuit breaker exceeds the maximum current threshold,
C) absorbing energy and avoiding overvoltage by means of the clamping circuit and shutting down the current path over the clamping circuit, **characterized in that** step C) comprises at least one of the steps:
C1) shutting down the current path over the clamping circuit while controlling the voltage over the clamping unit by means of the active gate driver or
C2) shutting down the current by subsequently opening (OFF) the switching units of the different modules of the clamping circuit.

12. Operation method according to claim 11, wherein step C1) comprises at least one of the steps:
C1-1) keeping the voltage over the clamping unit constant during the shut-off procedure,
C1-2) controlling the voltage over the clamping unit in accordance with a predefined target course for changing the voltage over the time;
C1-3) controlling the voltage over the clamping circuit (36) in order to compensate an influence of temperature, nonlinearities and/or V-I-characteristics of the at least one passive electrical device.

13. Operation method according to any of the claims 11 or 12, wherein step C2) comprises at least one of the steps:
C2-1) opening one or the next one of the modules depending from the voltage over the main switching unit (32) or
C2-2) opening one of or the next one of the modules when the voltage over the main switching unit (32) is or falls below a predefined minimum clamping voltage.

14. Control device for the solid state circuit breaker (14) according to any of the claims 1 to 8, or for the solid state circuit breaker of the electrical circuit according to claim 8 or of the aircraft according to any of the claims 9 or 10, wherein the control device is configured to cause the solid state circuit breaker (14) to execute the steps of the operation method according to any of the claims 11 to 13.

15. Computer program comprising instructions to cause the solid state circuit breaker (14) according to any of the claims 1 to 8, or the solid state circuit breaker of the electrical circuit according to claim 8 or of the aircraft according to any of the claims 9 or 10 to execute the steps of the operation method according to any of the claims 11 to 13.
